# EUROPÄISCHE PATENTSCHRIFT

(11) **EP 1 187 517 B1**
(45) Veröffentlichungstag und Bekanntmachung des Hinweises auf die Patenterteilung: **06.05.2004**
(21) Anmeldenummer: 01120446.8
(22) Anmeldetag: 27.08.2001
(51) Int. Cl.: H05K 3/12, B41N 1/24

(54) **Metallschablonen**
Metal stencils
Stencils métalliques

(30) Priorität: 04.09.2000 DE 10043471
(43) Veröffentlichungstag der Anmeldung: 13.03.2002
(73) Patentinhaber: LaserJob GmbH, 82284 Grafrath (DE)
(72) Erfinder: Kleemann, Georg, 82288 Kottgeisering (DE); Englmaier, Robert, 86929 Penzing (DE)
(74) Vertreter: Bösl, Raphael, Dr. rer. nat., Dipl.-Chem.

(56) Entgegenhaltungen:
- DE-A- 19 926 941
- US-A- 5 804 248

## Beschreibung

Die Erfindung betrifft Schablonen oder Masken für den Auftrag von Lotpaste auf Leiterplatten und Leiterfolien, insbesondere auf SMD-Leiterplatten (SMD = Surface-Mounted Device). In den genannten Schablonen sind Durchbrechungen eines Druckbildes zur Aufnahme von Lotpaste ausgebildet. Bei dem Lotpastenauftrag wird die Schablone in einer Druckmaschine über einer vorgefertigten Leiterplatte oder einer flexiblen Leiterfolie, insbesondere einer SMD-Leiterplatte, mit darauf ausgebildeten Leiterbahnen angeordnet, und Lotpaste wird mit einem Rakel in die Durchbrechungen der Schablone gedrückt. Nach dem Abnehmen der Schablone sind auf der Leiterplatte Lotpastendepots angeordnet, auf die elektronische oder elektromechanische Bauteile aufgesetzt werden können. Durch Erhitzen und Schmelzen der Lotpastendepots in einem Reflowofen können die Bauteile mit den darunter befindlichen Leiterbahnen der SMD-Leiterplatte verlötet werden.

Das Volumen eines Lotpastendepots, d.h. die Menge der aufgetragenen Lotpaste im Bereich einer Durchbrechung der Schablone, wird durch die Grundfläche der Durchbrechung und die Stärke der Metallfolie bestimmt, aus der die Schablone gefertigt ist. Die Grundfläche einer Durchbrechung ist durch die Anordnung der Anschlußstellen an einem Bauteil weitgehend vorbestimmt und kann nur in geringem Maße verändert werden. Da ein zu geringes Lotpastenvolumen insbesondere bei größeren elektronischen oder elektromechanischen Bauteilen zu einem merklichen Ansteigen der Ausschußrate der fertiggestellten SMD-Leiterplatten führt, besteht eine Nachfrage nach Schablonen mit Bereichen unterschiedlicher Stärke und mit Durchbrechungen vorbestimmter Tiefe innerhalb eines Druckbildes.

Im Stand der Technik sind sog. Electro-Formed Stencils für den Lotpastenauftrag auf SMD-Leiterplatten bekannt. Electro-Formed Stencils sind Schablonen in Form von Nickelfolien, die in einem galvanischen Verfahren hergestellt werden. Bei der Herstellung der Electro-Formed Stencils wird eine Nickelfolie aus einem Nickelhaltigen Elektrolyten auf der Oberfläche eines Metallblocks abgeschieden. Auf der Oberfläche des Metallblocks sind Flächen angeordnet, die mit Fotolack abgedeckt sind und die in ihrer Form und Anordnung den Durchbrechungen der Nickelfolie entsprechen. Die Nickelfolie entsteht während des galvanischen Verfahrens durch Abscheiden von Nickel in den tieferen Bereichen der Oberfläche des Stahlblocks, die nicht mit Photolack abgedeckt sind. Durch anschließendes Abdecken von ausgewählten Bereichen der Nickelfolie mit Photolack und Fortsetzen des galvanischen Verfahrens werden Nickelfolien mit Bereichen unterschiedlicher Stärke und mit Durchbrechungen unterschiedlicher Tiefe hergestellt. Die Nachteile der Electro-Formed Stencils bestehen in der langen Herstellungszeit von mehreren Arbeitstagen und den hohen Herstellungskosten.

Außerdem sind im Stand der Technik Schablonen für den Lotpastenauftrag auf SMD-Leiterplatten bekannt, die durch Ausschneiden von Durchbrechungen in einer Stahlfolie mit einem Laser und galvanisches Abscheiden von Nickelschichten auf vorbestimmten Bereichen der Oberfläche der Stahlschablone hergestellt werden. Die vorstehend genannten Stahlschablonen mit galvanisch aufgelagerten Nickelschichten weisen ebenfalls die Nachteile einer langen Herstellungszeit und hoher Kosten auf und besitzen außerdem ein zu geringe Haltbarkeit. Da die Schablonen beim Druckvorgang einer kräftigen Walkbewegung ausgesetzt sind, können die Nickelschichten sich bereits nach kurzzeitigem Gebrauch ablösen.

Daneben besteht eine Nachfrage nach Schablonen für den Lotpastenauftrag auf Leiterplatten und Leiterfolien, insbesondere auf SMD-Leiterplatten, die Ausnehmungen auf der Schablonenunterseite aufweisen, die dem Schutz von Oberflächenbestandteilen von SMD-Leiterplatten bei dem Druckvorgang dienen. Im Stand der Technik sind Metallschablonen für den Lotpastenauftrag auf SMD-Leiterplatten bekannt, die Ausnehmungen auf der Schablonenunterseite aufweisen. Dabei sind die Ausnehmungen jedoch mit einem Ätzverfahren hergestellt, das nachteiliger Weise bei der Herstellung der Schablonen zusätzlich zu dem übrigen Herstellungsverfahren durchgeführt werden muß.

Die Aufgabe der Erfindung betrifft die Bereitstellung von Schablonen oder Masken, insbesondere für den Auftrag von Lotpaste auf Leiterplatten und/oder Leiterfolien und insbesondere auf SMD-Leiterplatten, mit ausgewählten Bereichen unterschiedlicher Stärke mit Durchbrechungen vorbestimmter Tiefe, die schneller und kostengünstiger herstellbar sind als die Schablonen des Standes der Technik und/oder eine verbesserte Haltbarkeit besitzen.

Die Aufgabe der Erfindung wird mit den kennzeichnenden Merkmalen von Anspruch 1 gelöst.

Im folgenden wird die Erfindung anhand von vorteilhaften Ausführungsbeispielen und von Figuren beschrieben.

Dabei zeigt:
- Figur 1: ein Zwischenprodukt bei der Herstellung von erfindungsgemäßen Metallschablonen, im Schnitt.
- Figur 2: eine erfindungsgemäße Metallschablone im Schnitt.
- Figur 3: eine Anordnung einer erfindungsgemäßen Metallschablone über einer SMD-Leiterplatte, im Schnitt.
- Figur 4: eine erfindungsgemäße Metallschablone in perspektivischer Darstellung.
- Figur 5: eine weitere erfindungsgemäße Metallschablone im Schnitt.
- Figur 6: eine weitere erfindungsgemäße Metallschablone im Schnitt.
- Figur 7: eine weitere erfindungsgemäße Metallschablone im Schnitt.

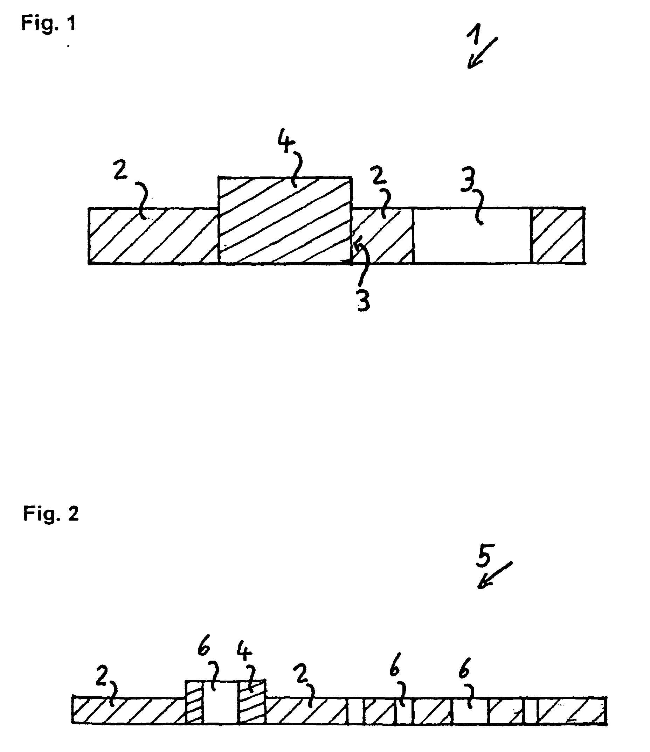

Figur 1 zeigt ein Zwischenprodukt 1 bei der Herstellung von erfindungsgemäßen Metallschablonen. Das Zwischenprodukt 1 besteht aus einer Metallfolie 2 mit wenigstens einer ersten Durchbrechung 3, in die ein Patch 4 mit vorbestimmter Stärke eingefügt ist. Das Patch 4 ist mit der Metallfolie 2 fest verbunden. Die Metallfolie 2 besteht vorteilhafter Weise aus nicht-rostendem Metall, insbesondere aus Edelstahl, beispielsweise Chrom-Nickel-Stahl, oder aus Nickel, Titan, Molybdän oder aus einer Legierung mit diesen Metallen. Bei vorteilhaften Ausführungsformen der Erfindung sind die ersten Durchbrechungen 3 zur Aufnahme der Patches 4 mit einem Laser aus der Metallfolie 2 ausgeschnitten.

Ein erfindungsgemäßes Patch 4 besteht aus einem Material ausreichender Härte und/oder Abriebfestigkeit für ein Siebdruckverfahren, insbesondere zum Auftrag von Lotpaste auf SMD-Leiterplatten. Vorteilhafter Weise besteht ein Patch 4 aus nicht-rostendem Metall, insbesondere aus Edelstahl, beispielsweise Chrom-Nickel-Stahl, oder aus Nickel, Titan, Molybdän oder aus einer Legierung mit diesen Metallen oder aus einem ausgewählten Kunststoff mit ausreichender Härte und Abriebfestigkeit. Vorteilhafter Weise ist ein Patch 4 mit einem Laser aus einer Metallfolie ausgeschnitten. Erfindungsgemäß besitzt ein Patch 4 eine vorbestimmte Stärke und Form und eine ausreichend große Fläche zur Ausbildung von wenigstens einer Durchbrechung zur Aufnahme von Lotpaste und/oder zur Ausbildung einer Ausnehmung auf der Unterseite einer Schablone. Ein Patch 4 und die zugehörige erste Durchbrechung 3 einer Metallfolie 2 sind in Form und Größe vorteilhafter Weise weitgehend aneinander angepaßt.

Erfindungsgemäß ist ein Patch 4 in eine erste Durchbrechung 3 der Metallfolie 2 eingefügt und fest mit dieser verbunden. Bei vorteilhaften Ausführungsformen der Erfindung bestehen die Patches 4 aus Metall und sind mit der Metallfolie 2 verschweißt, insbesondere durch Laserschweißen oder durch Elektronenstrahlschweißen. Bei weiteren vorteilhaften Ausführungsformen der Erfindung bestehen die Patches 4 aus Metall oder Kunststoff und sind in erste Durchbrechungen 3 der Metallfolie 2 eingeklebt. Bei weiteren vorteilhaften Ausführungsformen sind die Patches 4 mit der Metallfolie (2) durch mechanisches Verkeilen fest verbunden.

Figur 2 zeigt eine erfindungsgemäße Metallschablone 5 zum Auftrag von Lotpaste auf Leiterplatten und/oder Leiterfolien, insbesondere auf SMD-Leiterplatten. In der Metallschablone 5 sind Durchbrechungen 6 eines Druckbildes ausgebildet. Die Durchbrechungen 6 können in einem Druckverfahren Lotpaste aufnehmen. Die Durchbrechungen 6 sind in wenigstens einem Patch 4 und/oder in der Metallfolie 2 ausgebildet. Bei vorteilhaften Ausführungsformen sind die Durchbrechungen 6 mit einem Laser aus der Metallfolie 2 ausgeschnitten. Bei Patches 4 aus Metall oder aus einem mit Laser schneidbaren Kunststoff sind die Durchbrechungen 6 in den Patches 4 vorteilhafter Weise ebenfalls mit einem Laser ausgeschnitten.

Das Volumen einer Durchbrechung 6 zur Aufnahme von Lotpaste ist durch die Grundfläche der Durchbrechung 6 und erfindungsgemäß durch die vorbestimmte Stärke eines Patches 4 oder der Metallfolie 2 bestimmt. In dem Ausführungsbeispiel in Figur 2 besitzt das Patch 4 eine vorbestimmte größere Stärke als die Metallfolie 2 und bildet mit deren Oberfläche eine Stufe. Durch die Auswahl der Stärke der Patches 4 oder der Metallfolie 2 wird erfindungsgemäß die Auswahl eines Lotpastenvolumens ermöglicht, das auf einer vorbestimmtem Fläche einer Leiterplatte oder Leiterfolie aufgetragen werden soll.

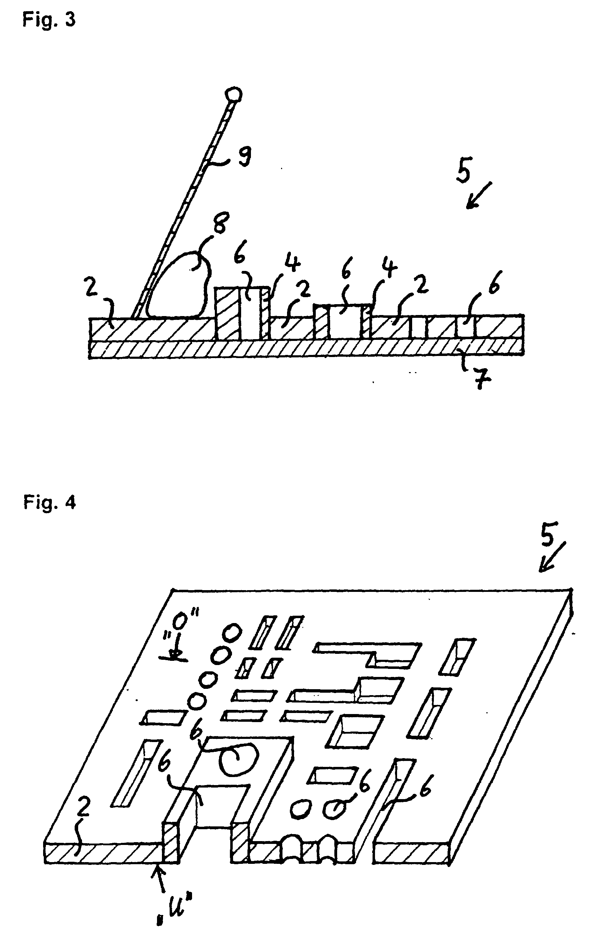

Figur 3 zeigt ein Beispiel einer vorteilhaften Anordnung einer erfindungsgemäßen Metallschablone 5 über einer Leiterplatte oder Leiterfolie, insbesondere über einer SMD-Leiterplatte 7, während eines Druckvorgangs. In der Metallfolie 2 der Metallschablone 5 ist wenigstens ein Patch 4 eingefügt und mit der Metallfolie 2 fest verbunden. In den Patches 4 und/oder der Metallfolie 2 sind die Durchbrechungen 6 eines Druckbildes ausgebildet. Die Metallschablone 5 liegt weitgehend plan auf der SMD-Leiterplatte 7 auf. Die Metallschablone 5 ist nach nicht gezeigten Leiterbahnen auf der SMD-Leiterplatte 7 ausgerichtet.

Bei einem Druckvorgang kann eine Lotpaste 8 mit einem Rakel 9 über die Metallschablone 5 gestrichen und in die Durchbrechungen 6 der Patches 4 und/oder der Metallfolie 2 gedrückt werden. Dabei besitzen die erfindungsgemäßen Metallschablonen (5) mit den fest eingefügten Patches (4) eine vorteilhafte hohe mechanische Stabilität. Nach dem Abnehmen der Metallschablone 5 sind Depots der Lotpaste 8 auf der SMD-Leiterplatte 7 angeordnet. Die Anordnung der Depots der Lotpaste 8 auf der SMD-Leiterplatte 7 ist durch die Anordnung der Durchbrechungen 6 in der Metallfolie 2 und/oder in den Patches 4 bestimmt. Das Volumen eines Depots der Lotpaste 8 auf der SMD-Leiterplatte 7 ist durch das Volumen der zugehörigen Durchbrechung 6 in der Metallschablone 5 bestimmt. Bei vorbestimmter Fläche einer Durchbrechung 6 wird das Volumen eines Lotpastendepots erfindungsgemäß durch die vorbestimmte Stärke eines Patches 4 oder der Metallfolie 2 ausgewählt.

Figur 4 zeigt eine weitere erfindungsgemäße Metallschablone 5 mit Durchbrechungen 6 eines Druckbildes in der Metallfolie 2 und/oder in wenigstens einem Patch 4. Die Form und die Grundfläche einer Durchbrechung 6 ist vorteilhafter Weise an die Anordnung der Anschlußstellen eines elektronischen oder elektromechanischen Bauteils angepaßt, das an der zugehörigen Position auf der SMD-Leiterplatte festgelötet werden soll. Formen und Grundflächen der Durchbrechungen 6 in den erfindungsgemäßen Metallschablonen 5 umfassen beliebige vorteilhafte Formen und Grundflächen.

Bei vorteilhaften Ausführungsformen besitzt wenigstens ein Patch 4 der Metallschablone 5 eine größere Stärke als die Metallfolie 2, schließt weitgehend plan mit der Unterseite "U" der Metallfolie 2 ab und bildet mit der Oberfläche "O" der Metallfolie 2 eine Stufe. Wegen seiner größeren Stärke überragt das Patch 4 die Oberfläche "O" der Metallfolie 2. In einem vorteilhaften Ausführungsbeispiel besitzt die Metallfolie 2 beispielsweise eine Stärke von 150 µm, und wenigstens ein Patch 4 besitzt eine Stärke von 200 µm und überragt die Oberfläche "O" der Metallfolie 2 um ca. 50 µm.

Bei Patches 4 aus Metall, die durch Einschweißen mit der Metallfolie 2 verbunden sind, kann die Stärke der Patches 4 in ihrem Randbereich infolge des Einschweißens verringert sein. Bei Patches 4 aus Metall oder aus Kunststoff kann der Randbereich außerdem in vorteilhafter Weise ausgebildet sein und insbesondere abgeschrägt sein, um den Auftrag der Lotpaste 8 oder das Einfügen der Patches 4 in erste Durchbrechungen 3 der Metallfolie 2 zu erleichtern. Patches (4), die mittels mechanischem Verkeilen in die Metallfolie (2) fest eingefügt werden, können vorteilhafter Weise einen konischen Querschnitt besitzen.

Die Durchbrechungen 6 in Patches 4, die eine größere Stärke besitzen als die Metallfolie 2, besitzen eine größere Tiefe als die Durchbrechungen 6 in der Metallfolie 2 und können bei gleicher Grundfläche ein größeres Volumen einer Lotpaste aufnehmen. Vorteilhafter Weise sind Patches 6 mit größerer Stärke als die Metallfolie 2 in denjenigen Bereichen der erfindungsgemäßen Metallschablonen 5 angeordnet, in denen Durchbrechungen 4 für Lotpastendepots mit vergleichsweise großen Volumina für große elektronische oder elektromechanische Bauteile bevorzugt sind.

Bei weiteren vorteilhaften Ausführungen weisen die erfindungsgemäßen Metallschablonen 5 eine Mehrzahl von wenigstens 2 Patches 4 auf, deren Stärke unterschiedlich und jeweils größer ist als die Stärke der Metallfolie 2. Die Patches 4 schließen weitgehend plan mit der Unterseite "U" der Metallfolie 2 ab und bilden Stufen unterschiedlicher Höhe mit der Oberfläche "O" der Metallfolie 2. Die Patches 4 überragen die Oberfläche "O" der Metallfolie 2 um die jeweilige Differenz ihrer Stärke und der Stärke der Metallfolie 2. Durchbrechungen 6 mit gleicher Grundfläche besitzen in den Patches 4 unterschiedlicher Stärke eine unterschiedliche Tiefe. Dadurch wird erfindungsgemäß eine Variation des Lotpastenvolumens erreicht, das Durchbrechungen 6 mit gleicher Grundfläche aufnehmen können.

Bei vorteilhaften Ausführungsformen der erfindungsgemäßen Metallschablonen 5 sind die Anzahl, Formen, Stärken und die Anordnung der Patches 4 sowie die Anzahl, Formen und die Anordnung der Durchbrechungen 6 in den Patches 4 und/oder in der Metallfolie 2 vorteilhafter Weise an den erforderlichen Lotpastenauftrag angepaßt.

Ohne Beschränkung für die Erfindung besitzen die Metallfolien 2 der erfindungsgemäßen Metallschablonen 5 beispielsweise eine Stärke von 30 µm bis 250 µm, und die Patches 4 besitzen beispielsweise eine Stärke von 50 µm bis 500 µm.

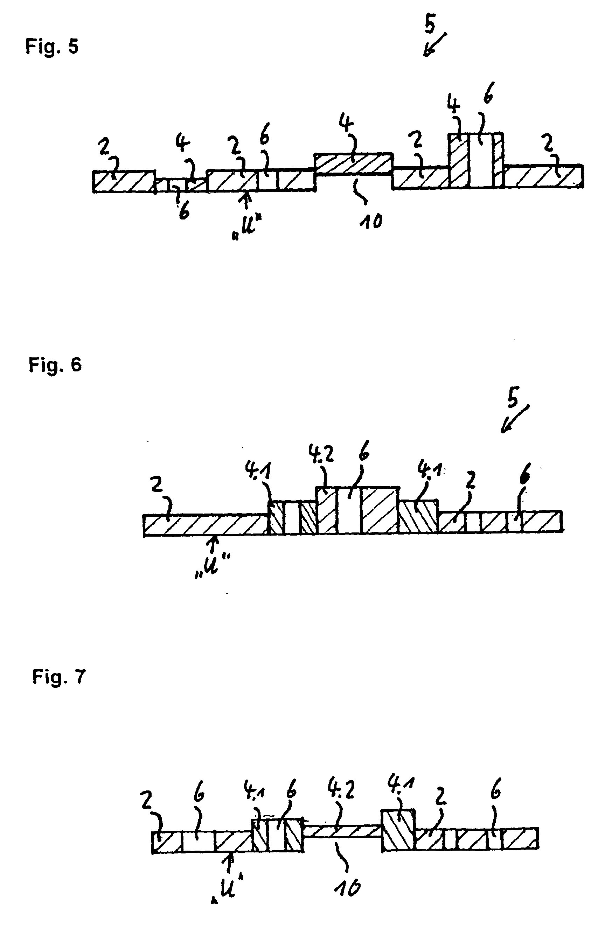

Figur 5 zeigt ein Ausführungsbeispiel von erfindungsgemäßen Metallschablonen 5 mit wenigstens einer Ausnehmung 10 in der Unterseite "U" der Metallfolie 2. Die Ausnehmung 10 wird an ihrem oberen Ende von einem Patch 4 begrenzt, das in die Metallfolie 2 eingefügt und mit dieser fest verbunden ist. Dabei bildet das Patch 4 eine Stufe mit der Unterseite "U" der Metallfolie 2. Die Höhe der Stufe zwischen der Unterseite "U" der Metallfolie 2 und dem Patch 4 ist vorteilhafter Weise so gewählt, daß die Ausnehmung 10 eine Oberflächenstruktur einer SMD-Leiterplatte bei einem Druckvorgang aufnehmen kann. Das Patch 4 über der Ausnehmung 10 kann beispielsweise die gleiche, eine geringere oder eine größere Stärke besitzen wie die Metallfolie 2.

Figur 5 zeigt außerdem ein Ausführungsbeispiel von erfindungsgemäßen Metallschablonen 5, die wenigstens ein Patch 4 vorbestimmter Stärke aufweisen, das in eine Metallfolie 2 größerer Stärke eingefügt und mit dieser fest verbunden ist. Bei vorteilhaften Ausführungsformen schließt wenigstens ein Patch 4 vorbestimmter Stärke mit der Unterseite "U" der Metallfolie 2 größerer Stärke weitgehend plan ab. Das Patch 4 bildet eine Stufe mit der Oberfläche "O" der Metallfolie 2 größerer Stärke, die im Bereich des Patches 4 eine stufenförmige Vertiefung 11 aufweist. Metallschablonen 5 mit stufenförmigen Vertiefungen 11 in der Metallfolie 2 können beispielsweise große zusammenhängende Bereiche mit tiefen Durchbrechungen 6 in der Metallfolie 2 und einzelne stufenförmige Vertiefungen 11 mit Durchbrechungen 6 geringerer Tiefe aufweisen. In einem vorteilhaften Ausführungsbeispiel ist beispielsweise mindestens ein Patch 4 mit einer Stärke von 150 µm in eine Metallfolie 2 mit einer Stärke von 200 µm eingefügt und fest verbunden und bildet mit der Oberfläche der Metallfolie 2 eine stufenförmige Vertiefung 11 von ca. 50 µm.

Figur 6 zeigt ein weiteres vorteilhaftes Ausführungsbeispiel der erfindungsgemäßen Metallschablonen. In die Metallfolie 2 ist ein erstes Patch 4.1 vorbestimmter Stärke eingefügt und fest verbunden. In das Patch 4.1 ist ein zweites Patch 4.2 vorbestimmter Stärke eingefügt und fest verbunden. Die Patches 4.1 und 4.2 schließen weitgehend plan mit der Unterseite "U" der Metallfolie 2 ab. In der Metallfolie 2 und den Patches 4.1 und 4.2 können eine beliebige Anzahl von Durchbrechungen 6 mit beliebiger Fläche ausgeschnitten sein.

Vorteilhafte Ausführungen der erfindungsgemäßen Metallfolien 5 enthalten eine beliebige Anzahl von Patches 4 beliebiger Stärke und Form, die in beliebiger Anordnung ineinander eingefügt sind und/oder teilweise ineinander und teilweise in die Metallfolie 2 eingefügt sind und/oder in die Metallfolie 2 eingefügt sind und fest miteinander und/oder der Metallfolie 2 verbunden sind. Die Patches 4 schließen weitgehend plan mit der Unterseite "U" der Metallfolie 2 ab und können vorzugsweise Durchbrechungen 6 enthalten und/oder die Patches 4 bilden mit der Unterseite "U" der Metallfolie 2 eine Stufe und begrenzen eine Ausnehmung 10 auf der Unterseite "U" der Metallfolie 2.

Figur 7 zeigt eine weitere vorteilhafte Ausführungsform von erfindungsgemäßen Metallfolien 5 mit einer Ausnehmung 10 auf der Unterseite "U" der Metallfolie 2. Die Ausnehmung 10 ist durch wenigstens 2 Patches 4 beliebiger Stärke gebildet, die ineinander gefügt sind. Beispielsweise ist ein kleineres Patch 4.2 vollständig in ein größeres Patch 4.1 eingefügt und fest verbunden. Das größere Patch 4.1 schließt weitgehend plan mit der Unterseite "U" der Metallfolie 2 ab. Das kleinere Patch 4.2 bildet mit der Unterseite des größeren Patches 4.1 eine Stufe und begrenzt eine Ausnehmung 10 auf der Unterseite "U" der Metallschablone 5. Aus dem größeren Patch 4 kann wenigstens eine Durchbrechung 6 zur Aufnahme von Lotpaste ausgeschnitten sein.

In weiteren vorteilhaften Ausführungsbeispielen mit Ausnehmungen 10 auf der Schablonenunterseite schließen eine Mehrzahl von Patches 4 weitgehend plan mit der Unterseite der Metallfolie 2 ab und bilden eine Stufe mit einem umschlossenen Patch 4, das das obere Ende einer Ausnehmung 10 begrenzt. Die vorstehend beschriebenen Ausnehmungen 10 können mit weiteren Ausführungen der erfindungsgemäßen Metallschablonen beliebig kombiniert sein.

Ein vorteilhaftes Ausführungsbeispiel der Erfindung betrifft ein Verfahren zur Herstellung der erfindungsgemäßen Metallschablonen 5. In einem ersten Schritt werden in einer Metallfolie 2 mit vorbestimmter Stärke mit einem Laser erste Durchbrechungen 3 zur Aufnahme von Patches 4 ausgeschnitten und werden aus einem Stahlblech mit vorbestimmter Stärke Patches 2 mit entsprechender Form und Größe ausgeschnitten.

In einem zweiten Schritt des erfindungsgemäßen Verfahrens zur Herstellung der Metallschablonen 5 werden die Metallfolie 2 und wenigstens ein Patch 4 aus dem ersten Schritt in einer Ebene angeordnet und ausgerichtet. Die Patches 4 werden in die entsprechenden ersten Durchbrechungen 3 der Metallfolie 2 eingefügt und ausgerichtet. In einem dritten Schritt werden die Patches 4 mit der Metallfolie 2 mit einem Laser verschweißt, verklebt oder mechanisch verkeilt.

Ausnehmungen 10 in der Unterseite der Metallschablone 5 können ausgebildet werden, indem beipielsweise ein Stück Metallfolie vorbestimmter Stärke und Größe unter einem Patch 4 angeordnet wird, das mit der Metallfolie 2 fest verbunden werden soll, und wobei nur das Patch 4 mit der Metallfolie (2) verbunden wird.

Vorteilhafter Weise können die erfindungsgemäßen Metallschablonen 5 in einem Rahmen einer Druckmaschiene in beliebiger Weise, insbesondere auch unter Zugspannung, lösbar oder unlösbar gehalten sein.

## Patentansprüche

1. Metallschablone mit Bereichen unterschiedlicher Stärke zum Aufbringen von Stoffen auf Träger, wobei die Stoffe auf dem Träger unterschiedliche Höhen aufweisen, **dadurch gekennzeichnet, daß** wenigstens ein Bereich von einem Patch (4) gebildet ist, das in eine Durchbrechung (3) der Metallschablone fest eingefügt ist.

2. Metallschablone (5) nach Anspruch 1 für den Auftrag von Lotpaste, insbesondere auf SMD-Leiterplatten, die eine Metallfolie (2) mit wenigstens einer Durchbrechung (3) umfaßt, in die ein Patch (4) fest eingefügt ist.

3. Metallschablone (5) nach Anspruch 1 oder 2, wobei das Patch (4) wenigstens eine Durchbrechung (6) zur Aufnahme einer ausgewählten Menge der Lotpaste aufweist.

4. Metallschablone (5) nach einem oder mehreren der Ansprüche 1 bis 3 mit wenigstens einer Ausnehmung (10) in der Unterseite (U) der Metallfolie (2) zur Aufnahme von wenigstens einem Oberflächenbestandteil der SMD-Leiterplatte (7).

5. Metallschablone (5) nach einem oder mehreren der Ansprüche 1 bis 4 mit wenigstens einem Patch (4), das mit der Oberfläche (O) und/oder der Unterseite (U) der Metallfolie (2) wenigstens eine Stufe bildet.

6. Metallschablone (5) nach einem oder mehreren der Ansprüche 1 bis 5 mit wenigstens einer Durchbrechung (6) in der Metallfolie (2) zur Aufnahme von Lotpaste.

7. Metallschablone (5) nach einem oder mehreren der Ansprüche 1 bis 6 mit wenigstens zwei Patches (4), die sich überlappen oder ineinander gefügt sind und miteinander und/oder mit der Metallfolie (2) fest verbunden sind.

8. Metallschablone (5) nach Anspruch 7 mit wenigstens zwei Patches (4), die miteinander wenigstens eine Stufe bilden.

9. Metallschablone (5) nach einem oder mehreren der Ansprüche 1 bis 8 mit wenigstens einem eingeschweißten Patch (4) aus Metall und/oder wenigstens einem eingeklebten Patch (4) aus Metall oder Kunststoff.

10. Metallschablone (5) nach einem oder mehreren der Ansprüche 1 bis 9, wobei die Metallfolie (2) aus einem ersten nicht-rostenden Metall besteht.

11. Metallschablone (5) nach einem oder mehreren der Ansprüche 1 bis 10, wobei das Patch (4) aus dem ersten oder einem zweiten nicht-rostenden Metall oder aus einem Kunststoff mit einer Härte und/oder Abriebfestigkeit besteht, die an ein Siebdruckverfahren zum Lotpastenauftrag auf Leiterplatten, insbesondere SMD-Leiterplatten, angepaßt ist.

12. Verfahren zur Herstellung einer Metallschablone (5) nach einem oder mehreren der Ansprüche 1 bis 11, wobei in einem ersten Schritt wenigstens ein Patch (4) vorbestimmter Form und Größe und wenigstens eine zugehörige erste Durchbrechung (3) entsprechender Form und Größe in der Metallfolie (2) hergestellt, insbesondere mit einem Laser ausgeschnitten wird, wobei in einem zweiten Schritt das Patch (4) in die erste Durchbrechung (3) eingefügt und die Metallfolie (2) und das Patch (4) gegebenenfalls zueinander ausgerichtet werden, wobei in einem dritten Schritt das Patch (4) und die Metallfolie (2) fest miteinander verbunden, insbesondere mit einem Laser verschweißt werden, und wobei gegebenenfalls in einem vierten Schritt, insbesondere mit einem Laser, Durchbrechungen in dem Patch (4) und/oder in der Metallfolie (2) zur Einbringung von Lotpaste ausgeschnitten werden.

## Claims

1. Metal stencil with regions of different thickness for applying fabrics to supports, the fabrics having different heights on the support, **characterized in that** at least one region is formed by a patch (4), which is firmly inserted into an aperture (3) in the metal stencil.

2. Metal stencil (5) according to Claim 1 for the application of soldering paste, in particular on SMD printed circuit boards, which comprises a metal foil (2) with at least one aperture (3), into which a patch (4) is firmly inserted.

3. Metal stencil (5) according to Claim 1 or 2, the patch (4) having at least one aperture (6) for receiving a selected amount of the soldering paste.

4. Metal stencil according to one or more of Claims 1 to 3 with at least one recess (10) in the underside (U) of the metal foil (2) for receiving at least one part of the surface of the SMD printed circuit board (7).

5. Metal stencil (5) according to one or more of Claims 1 to 4 with at least one patch (4), which forms at least one step with the surface (O) and/or the underside (U) of the metal foil (2).

6. Metal stencil (5) according to one or more of Claims 1 to 5 with at least one aperture (6) in the metal foil (2) for receiving soldering paste.

7. Metal stencil (5) according to one or more of Claims 1 to 6 with at least two patches (4), which overlap or are inserted one in the other and are firmly connected to one another and/or to the metal foil (2).

8. Metal stencil (5) according to Claim 7 with at least two patches (4), which together form at least one step.

9. Metal stencil (5) according to one or more of Claims 1 to 8 with at least one welded-in patch (4) of metal and/or at least one bonded-in patch (4) of metal or plastic.

10. Metal stencil (5) according to one or more of Claims 1 to 9, the metal foil (2) consisting of a first rust-proof metal.

11. Metal stencil (5) according to one or more of Claims 1 to 10, the patch (4) consisting of the first or a second rust-proof metal or of a plastic with a hardness and/or abrasion resistance which is adapted to a screen printing process for the application of soldering paste to printed circuit boards, in particular SMD printed circuit boards.

12. Method for producing a metal stencil (5) according to one or more of Claims 1 to 11, at least one patch (4) of a predetermined shape and size and at least one associated first aperture (3) of a corresponding shape and size being produced in the metal foil (2), in particular cut out by a laser, in a first step, the patch (4) being inserted into the first aperture (3) and the metal foil (2) and the patch (4) aligned if appropriate in relation to one another in a second step, the patch (4) and the metal foil (2) being firmly connected to each other, in particular welded by laser, in a third step, and, if appropriate, apertures in the patch (4) and/or in the metal foil (2) for the introduction of soldering paste being cut out, in particular by a laser, in a fourth step.

## Revendications

1. Pochoir métallique présentant des zones d'épaisseurs différentes pour l'application sur un support, les substances présentant sur des hauteurs différentes sur le support, **caractérisé en ce qu'**au moins une zone est formée par une pièce rapportée (4) insérée à demeure dans un passage (3) du pochoir métallique.

2. Pochoir métallique (5) selon la revendication 1, pour l'application de pâte à braser, en particulier sur des plaques à circuit imprimé de type CMS (composant monté en surface), comprenant une feuille métallique (2) présentant au moins un passage (3), dans lequel une pièce rapportée (4) est insérée à demeure.

3. Pochoir métallique (5) selon la revendication 1 ou 2, la pièce rapportée (4) présentant au moins un passage (6) pour recevoir une quantité sélectionnée de la pâte à braser.

4. Pochoir métallique (5) selon l'une ou plusieurs des revendications 1 à 3, comprenant au moins un évidement (10) ménagé en face inférieure (U) de la feuille métallique (2), afin de recevoir au moins un composant de surface de la plaque à circuit imprimé CMS (7).

5. Pochoir métallique (5) selon l'une ou plusieurs des revendications 1 à 4, comprenant au moins une pièce rapportée (4), formant au moins un étagement avec la face supérieure (O) et/ou la face inférieure (U) de la feuille métallique (2).

6. Pochoir métallique (5) selon l'une ou plusieurs des revendications 1 à 5, comprenant au moins un passage (6) ménagé dans la feuille métallique (2), afin de recevoir de la pâte à braser.

7. Pochoir métallique (5) selon l'une ou plusieurs des revendications 1 à 6, comprenant au moins deux pièce rapportées (4), se chevauchant ou bien étant jointes ou liées l'une à l'autre, et étant reliées rigidement ensemble et/ou à la feuille métallique (2).

8. Pochoir métallique (5) selon la revendication 7, comprenant au moins deux pièce rapportées (4), formant l'une avec l'autre au moins un étagement.

9. Pochoir métallique (5) selon l'une ou plusieurs des revendications 1 à 8, comprenant au moins une pièce rapportée (4) incorporée par soudage, réalisée en métal et/ou au moins une pièce rapportée (4) incorporée par collage, en métal ou en matière synthétique.

10. Pochoir métallique (5) selon l'une ou plusieurs des revendications 1 à 9, la feuille métallique (2) étant formée d'un premier métal inoxydable.

11. Pochoir métallique (5) selon l'une ou plusieurs des revendications 1 à 10, la pièce rapportée (4) étant formée du premier ou d'un deuxième métal inoxydable, ou bien d'une matière synthétique, d'une dureté et/ou d'une résistance à l'abrasion, adaptée à un procédé de sérigraphie pour l'application de pâte à braser sur des plaquettes à circuit imprimé, en particulier des plaquettes à circuit imprimé de type CMS.

12. Procédé de fabrication d'un Pochoir métallique (5) selon l'une ou plusieurs des revendications 1 à 11, où, lors d'une première étape au moins une pièce rapportée (4), de forme et de taille prédéterminées, et au moins un premier passage (3) afférent, de forme et de taille correspondantes, sont produits dans la feuillé métallique (2), en particulier par découpage avec un laser, où, lors d'une deuxième étape la pièce rapportée (4) est introduite dans le premier passage (3) et la feuille métallique (2) et la pièce rapportée (4) sont, le cas échéant, orientées l'une par rapport à l'autre, sachant que, lors d'une troisième étape, la pièce rapportée (4) et la feuille métallique (2) sont reliées rigidement ensemble, en particulier soudées avec un laser, et où, le cas échéant, lors d'une quatrième étape, en particulier effectuée avec un laser, des passages sont découpés dans la pièce rapportée (4) et/ou dans la feuille métallique (2), afin d'introduire de la pâte à braser.
